# EUROPÄISCHE PATENTSCHRIFT

(11) **EP 0 501 203 B1**
(45) Veröffentlichungstag und Bekanntmachung des Hinweises auf die Patenterteilung: **23.11.1994**
(21) Anmeldenummer: 92102052.5
(22) Anmeldetag: 07.02.1992
(51) Int. Cl.: F17C 3/08, F17C 13/00, G01R 33/38

(54) **Kryomagnetsystem mit störungsminimiertem Low-Loss-Heliumkryostat**
Cryomagnetsystem having a low-loss helium cryostat with minimised disturbance
Système cryomagnétique pourvu d'un cryostat à helium à pertes réduites ayant des dérangements minimalisés

(30) Priorität: 27.02.1991 DE 4106135
(43) Veröffentlichungstag der Anmeldung: 02.09.1992
(73) Patentinhaber: SPECTROSPIN AG, CH-8117 Fällanden (CH)
(72) Erfinder: Schittenhelm, Werner, Westford, MA 01886 (US); Martin, Charles, Arlington, MA 02174 (US); Weber, Beat, CH-8046 Zürich (CH); Mraz, Beat, CH-8634 Hombrechtikon (CH)
(74) Vertreter: KOHLER SCHMID + PARTNER

(56) Entgegenhaltungen:
- EP-A- 0 002 558
- GB-A- 2 087 061
- US-A- 4 878 350

## Beschreibung

Die Erfindung betrifft ein Kryomagnetsystem, insbesondere zur Anwendung bei Kernspinresonanz (NMR)- oder Ionen-Zyklotron-Resonanz(ICR)-Untersuchungen, mit einem verlustarmen Heliumkryostaten, der einen Heliumbehälter und eine oder mehrere dünnwandige Leitungen für die Aufhängung des Heliumbehälters und die Zufuhr bzw. Ableitung von Helium in den bzw. aus dem Heliumbehälter umfaßt, wobei die Leitungen mit mindestens einem Einweg-Niederdruck-Ventil gegen den Raum außerhalb des Heliumbehälters abgeschlossen sind.

Ein solches Kryomagnetsystem ist beispielsweise durch die DE-PS 31 53 405 bekannt.

Insbesondere Kryomagnetsysteme für die NMR-Spektrometrie werden heutzutage von extrem verlustarmen (Low-Loss) Heliumkryostaten gekühlt, die eine Verlustrate des flüssigen Heliums von nur 10 ml/h und darunter aufweisen. Dennoch sind bei einem solchen Low-Loss-Kryostaten herkömmlicher Bauweise die tatsächlich beobachteten Heliumverluste höher als die theoretisch berechneten, da sich bei diesen geringen Verlustraten auch Verlustquellen, die normalerweise vernachlässigt werden könnten, bereits bemerkbar machen.

Ein weiteres Problem bei den genannten herkömmlichen Kryomagnetsystemen stellen Störungen des erzeugten Magnetfeldes am Ort der zu untersuchenden Meßprobe dar, die offenbar innerhalb des Kryomagnetsystems entstehen. Während durch aufwendige Maßnahmen externe Störeinflüsse wie elektromagnetische Störfelder sowie erzwungene Vibrationen des Systems abgeschirmt bzw. kompensiert werden können, werden immer noch störende Seitenbänder bzw. Linienverbreiterungen in den NMR-Signalen beobachtet, die nur auf interne Störeinflüsse zurückzuführen sind.

Aufgabe der vorliegenden Erfindung ist es daher, ein Kryomagnetsystem zu entwickeln, bei dem die Helium-Verluste in Richtung auf das theoretische Limit reduziert sind und gleichzeitig interne Störungen des erzeugten Magnetfeldes am Ort der Meßprobe weitgehend minimiert sind.

Diese Aufgabe wird erfindungsgemäß dadurch gelöst, daß mindestens eine Abdampfleitung eine Vorrichtung zur Dissipation der Energie des bewegten Heliums aufweist.

Bei dem erfindungsgemäßen Kryomagnetsystem werden durch die in oder an den Leitungsrohren angebrachte Dissipationsvorrichtung thermisch getriebene akustische Schwingungen des Heliumgases im Leitungssystem verhindert oder zumindest stark gedämpft. Solche akustischen Schwingungen, deren Frequenzen in einem Bereich von ca. 10 bis 100 Hz liegen, können bei herkömmlichen Low-Loss-Kryostaten angeregt werden, weil die Leitungsrohre zum Heliumbehälter mit einem bei sehr geringen Überdruck im Heliumbehälter (z. B. 5 bis 10 mbar) öffnenden Einweg-Niederdruckventil gegen den Raum außerhalb des Heliumbehälters abgeschlossen werden müssen. Damit wird verhindert, daß bei zunehmendem äußeren Luftdruck feuchte Luft in das Kryomagnetsystem eindringen und im Heliumrohr Vereisungungen verursachen kann. Andererseits entsteht dadurch aber ein geschlossenes resonanzfähiges Volumen, dessen Schwingungsneigung viel höher ist als dies bei einem System mit offenen Zuleitungsrohren der Fall wäre. Die Anregung solcher Schwingungen wird durch die relativ hohe Temperaturdifferenz im Leitungssystem, die sich zwischen den Teilen der Leitung, die dem Heliumbehälter unmittelbar benachbart sind, und den behälterfernen Leitungsteilen aufbaut, stark begünstigt.

Die durch diese akustischen Schwingungen des Heliumgases erzeugten Druckstöße führen einerseits zu einer beträchtlichen Erhöhung der Abdampfverluste des Heliums, andererseits aber auch zu mechanischen Schwingungen im Bereich von 10 bis 100 Hz innerhalb des Kryostatensystems, sodaß eine Relativbewegung zwischen dem vom Kryomagneten erzeugten Magnetfeld und der Meßprobe entstehen kann. Die Meßprobe erfährt dann eine periodische Feldänderung (= Feldmodulation), was z. B. bei NMR-Spektren zu störenden Seitenbändern in Abständen von 10 bis 100 Hz und mit Intensitäten von mehreren Prozent des eigentlichen Meßsignals führen kann.

Diese Modulationserscheinungen können aber auch dadurch entstehen, daß dünnwandige metallische Flächen (vorzugsweise zwischen dem Kryomagneten und der Meßprobe) relativ zum Kryomagneten in Bewegung geraten, wodurch in ihnen Wirbelströme angeworfen werden, die ihrerseits zu Feldänderungen am Ort der Meßprobe führen können.

Ein besonderer Vorteil des erfindungsgemäßen Kryomagnetsystems besteht darin, daß mit einer einzigen Maßnahme, nämlich der Unterdrückung bzw. Dämpfung von thermo-akustischen Schwingungen des Heliumgases im Leitungssystem durch die Vorrichtung zur Dissipation der Energie des bewegten Heliums gleichzeitig sowohl die Heliumverluste des Kryostaten weiter vermindert, als auch die interne Ausbildung von elektromagnetischen Störfeldern im Kryomagnetsystem minimiert werden, so daß im Endeffekt bei einem verlustärmeren Betrieb des Kryomagnetsystems eine höhere Stabilität erzeugten Magnetfeldes erreicht wird.

Bei einer Ausführungsform des erfindungsgemäßen Kryomagnetsystems besteht die Vorrichtung zur Dissipation der Energie bewegten Heliums aus einer von einer Abdampfleitung abgezweigten Kammer, deren Wandmaterial eine hohe Dehnbarkeit und eine sehr geringe Federkonstante aufweist. Bei einem Druckstoß bläht sich die Kammer auf. Dabei wird die Energie der thermo-akustischen Schwingung im Helium zumindest teilweise an die sich ausdehnenden Wände der Kammer abgegeben, in Reibungsarbeit umgewandelt und so dem Gas entzogen, wodurch die Schwingung gedämpft wird.

Bei einer weiteren Ausführungsform wird die Kammer von einem dünnwandigen Faltenbalg gebildet. Ein solcher Faltenbalg ist in der Regel sehr haltbar und würde erst bei bedeutend höheren Druckspitzen als z. B. ein Gummiballon platzen. Daher besteht bei Anwendung eines Faltenbalges keine Notwendigkeit zu häufigerem Auswechseln.

Bei einer anderen Ausführungsform der Erfindung besteht die Vorrichtung zur Dissipation der Energie bewegten Heliums aus einem in einer Abdampfleitung vorgesehenen Strömungshindernis. Dieses wirkt für das strömende Gas als Schikane, so daß die kinetische Energie der thermo-akustischen Schwingung in Folge von Gasreibung an der Oberfläche des Hindernisses und durch Verwirbelungen des Gasstromes an die Umgebung abgegeben wird. Durch die Dissipation der kinetischen Energie des im Leitungsrohr bewegten Heliums können thermo-akustische Schwingungen ebenfalls gedämpft werden.

Bei einer Weiterbildung dieser Ausführungsform wird das Strömungshindernis von mindestens einer im Leitungsrohr der Abdampfleitung angebrachten porösen Scheibe gebildet. Dem durch die Kapillarkanäle des Scheibenmaterials hindurchtretenden Heliumgas wird aufgrund der dabei auftretenden Gasreibung ebenfalls Energie entzogen, was auch hier zu einer Dämpfung der thermoakustischen Schwingungen ausgenutzt wird. Eine solche poröse Scheibe kann aus Kunststoff bestehen, was den Vorteil einer billigen und einfachen Herstellung zeitigt. Bei einer anderen Ausführungsform besteht die poröse Scheibe aus Sintermaterial, insbesondere Sinterbronze und ist in handelsüblichen Pneumatikschalldämpfern erhältlich.

Vorzugsweise ist die poröse Scheibe an einem dem Heliumbehälter abgewandten Ende der Abdampfleitung vor dem Einweg-Niederdruckventil angeordnet, da am Leitungsende die Dämpfung besonders wirkungsvoll ist. Bei einer besonders bevorzugten Ausführungsform ist zwischen der porösen Scheibe und dem Einweg-Niederdruckventil ein Zwischengefäß mit einem größeren Innendurchmesser als dem Leitungsinnendurchmesser vorgesehen. Dadurch wird ein freies Durchströmen des Gases durch die poröse Scheibe gewährleistet, weil durch die Volumenerhöhung mit Hilfe des Zwischengefäßes verhindert wird, daß auf der dem Einweg-Niederdruckventil abgewandten Seite der porösen Scheibe ein Gegendruck im Gas aufgebaut wird.

Vorzugsweise sind die erfindungsgemäßen Vorrichtungen zur Dissipation der Energie bewegten Heliums in symmetrischer Weise an allen Abdampfleitungen vorgesehen. Dadurch wird eine symmetrische Energieabsorption über dem gesamten Abdampfsystem bewirkt. Insbesondere werden unterschiedliche Strömungs-, Temperatur- und Druckverhältnisse in den Abdampfleitungen vermieden, was ein geringes und gleichmäßiges Verdampfen des Heliums ermöglicht.

Da normalerweise diese Abdampfleitungen zugleich auch zur Aufhängung des Heliumbehälters dienen, können durch die obige Maßnahme unterschiedliche thermische Längenänderungen in den Aufhängungen und die dadurch hervorgerufene örtliche Verschiebung des Kryomagneten relativ zur Meßprobe verhindert werden. Eine solche Verschiebung wäre sehr unerwünscht, weil sie eine Veränderung des Betrages und eine Verschlechterung der Homogenität des erzeugten Magnetfeldes am Ort der Meßprobe zur Folge hätte.

Bei einer besonders einfachen Ausführungsform stehen alle Abdampfleitungen durch mindestens ein Verbindungsrohr miteinander in Kontakt, so daß lediglich eine Vorrichtung zur Dissipation der Energie bewegten Heliums an bzw. in dem Verbindungsrohr notwendig ist. Ebenso ist nur ein einziges Überdruckventil vonnöten, das ebenfalls an dem Verbindungsrohr angebracht ist.

Die Erfindung wird im folgenden anhand der in der Zeichnung dargestellten Ausführungsbeispiele näher beschrieben und erläutert. Die der Beschreibung und der Zeichnung zu entnehmenden Merkmale können bei anderen Ausführungsformen der Erfindung einzeln für sich oder zu mehreren in beliebiger Kombination Anwendung finden. Es zeigen
- Fig. 1: einen teilweisen Schnitt durch ein Kryomagnetsystem mit einer Magnetspule in einem Heliumbehälter;
- Fig. 2: eine räumliche Darstellung eines erfindunsgemäßen Kryomagnetsystems mit einem Faltenbalg zur Dissipation der Energie bewegten Heliums;
- Fig. 3a: eine räumliche Darstellung des oberen Teils eines erfindungsgemäßen Heliumkryostaten mit verbundenen Abdampfleitungen und angeflanschtem Zwischengefäß mit Strömungshindernis; und
- Fig. 3b: eine teilweise aufgeschnittene Detailansicht des Zwischengefäßes mit einer porösen Scheibe als Strömungshindernis.

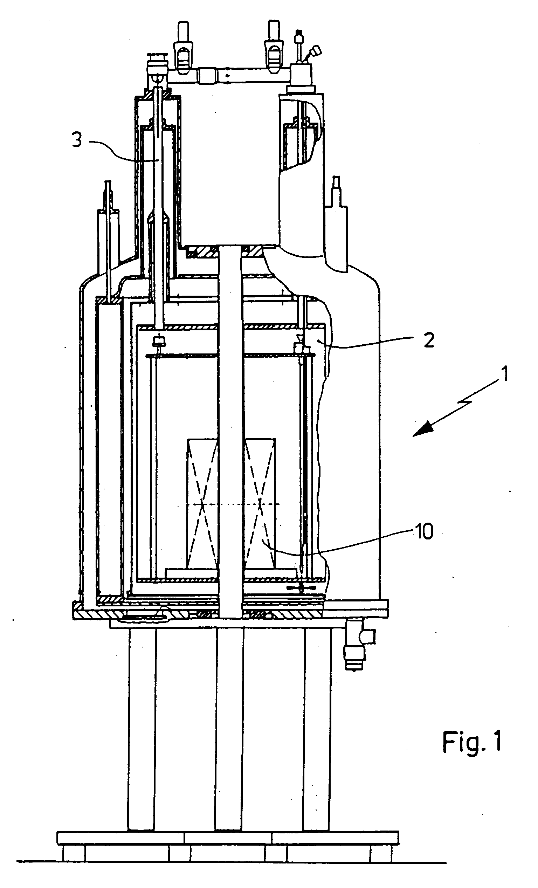

Das in Fig. 1 dargestellte Kryomagnetsystem umfaßt einen Heliumkryostaten 1 mit einem Heliumbehälter 2, in dessen Inneren sich die Magnetspule 10 befindet. Derartige Magnetsysteme finden insbesondere Anwendung bei Kernspinresonanz (NMR)- Untersuchungen, wo von einer supraleitenden Magnetspule extrem hohe und hochgradig homogene Magnetfelder erzeugt werden müssen. Auch bei Ionenzyklotronresonanz (ICR)-Untersuchungen werden ähnliche Kryomagnetsysteme verwendet, bei denen der Heliumbehälter 2 auch an zwei dünnwandigen Rohren aufgehängt ist, der Kryomagnet jedoch liegend eingebaut ist und ein horizontal orientiertes Magnetfeld erzeugt. Auch hier gelten die gleichen Überlegungen wie für das erstgenannte NMR-Kryomagnetsystem. Das zur Kühlung der supraleitenden Magnetspule 10 erforderliche flüssige Helium stellt einen nicht unbedeutenden Kostenfaktor für den Betrieb eines solchen Systems dar. Daher wird schon seit längerer Zeit versucht, durch diverse Isolierungen und andere bauliche Maßnahmen die Verlustraten an flüssigem Helium möglichst gering zu halten. Typische "Low-Loss-"Kryostaten für NMR-Spektrometer weisen eine Verlustrate des flüssigen Heliums in der Gegend von 10 ml/h auf. Das abdampfende Helium verläßt den Heliumbehälter 2 über eine oder mehrere Abdampfleitungen 3, an deren Enden es entweder in die Atmosphäre gelangt oder zur Wiederverwendung aufgesammelt wird.

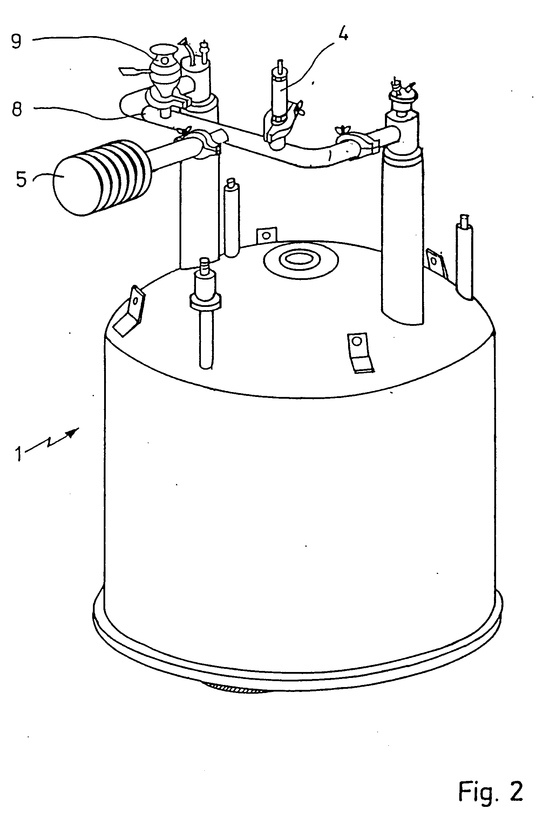

Bei verlustarmen Kryostaten müssen die Nachfüll- und Abdampfleitungen 3 mit einem oder mehreren Einweg-Niederdruckventilen 4, die bei ca. 5 bis 10 mbar öffnen, gegen die äußere Atmosphäre abgeschlossen werden, um zu verhindern, daß bei zunehmendem äußeren Luftdruck feuchte Luft im Zuleitungssystem zum Kryostaten Vereisungen verursachen kann. Ein solches Einweg-Niederdruckventil 4 ist beispielsweise in Fig. 2 dargestellt.

In dem geschlossenen Volumen eines solchen Low-Loss-Kryostaten können sich nun durch die Temperaturunterschiede zwischen den mit dem flüssigen Helium in Kontakt stehenden Teilen und den auf Zimmertemperatur befindlichen Teilen des Systems thermisch getriebene akustische Schwingungen in den Abdampfleitungen 3 aufbauen. Diese Schwingungen des Heliumgases im Leitungssystem führen einerseits zu einer beträchtlichen Erhöhung der Heliumverlustrate des Kryostaten. Andererseits regen sie mechanische Schwingungen der Wände und anderer metallischen Teile des Kryostaten an. Dadurch kommt es, wie oben ausgeführt, einerseits zu Relativbewegungen zwischen der Meßprobe und dem von der Magnetspule 10 erzeugten Magnetfeld, andererseits werden Wirbelströme in den dünnwandigen metallischen Flächen zwischen Magnetspule 10 und Meßprobe angeworfen, was zu zeitlichen Veränderungen des Magnetfeldes am Ort der Meßprobe führt. Bei NMR-Spektrometern werden dadurch unerwünschte Seitenbänder im Spinresonanzspektrum erzeugt, die zu einer Verfälschung des gemessenen Spektrums führen.

Sowohl die erhöhten Heliumverluste als auch die erwähnte störende Feldmodulation können vermieden werden, wenn die Ursache der Störungen, nämlich die thermisch getriebenen akustischen Schwingungen beseitigt oder zumindest minimiert werden. Dies geschieht erfindungsgemäß durch eine Dämpfung der thermo-akustischen Schwingungen mit Hilfe einer Vorrichtung zur Dissipation der Energie des bewegten Heliums in den Abdampfleitungen 3.

Eine konkrete Ausgestaltung einer solchen Vorrichtung besteht in einer an einer Abdampfleitung 3 abgezweigten Kammer, deren Wandmaterial eine hohe Dehnbarkeit und leichte Verformbarkeit bis in die Nähe des plastischen Bereichs bei kleiner Federkonstante aufweist. Eine einfache Ausführungsform einer solchen Kammer ist ein in Fig. 2 gezeigter dünnwandiger Faltenbalg 5.

Damit wird zumindest ein Teil der Energie aus der thermo-akustischen Schwingung des Heliumgases auf das sich unter dem Druckstoß ausdehnende Wandmaterial der Kammer übertragen und so der Schwingung entzogen, was zu einer Schwingungsdämpfung führt. Wichtig ist die leichte Verformbarkeit der Kammerwände, damit sich die Kammer bei dem vorhandenen geringen Überdruck von nur ca. 5 bis 10 mbar voll entfalten kann.

Eine andere Möglichkeit der Realisierung einer Vorrichtung zur Dissipation der Energie des bewegten Heliums und zur Dämpfung der thermo-akustischen Schwingungen ist der Einbau eines oder mehrerer Strömungshindernisse in das System von Abdampfleitungen 3. Die Strömungshindernisse wirken als Schikane für den Gasstrom, erzwingen eine Wirbelbildung oder erzeugen Gasreibung, wobei die Energie hierfür der schwingenden Gassäule entnommen wird.

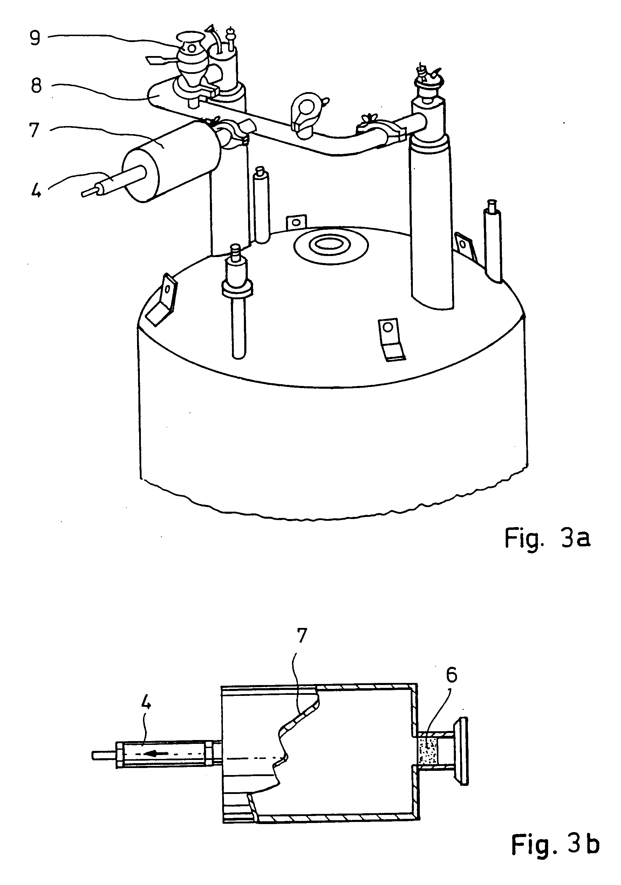

Eine mögliche Form eines solchen Strömungshindernisses ist in Fig. 3b angedeutet, wo eine im Leitungsrohr angebrachte poröse Scheibe 6 dargestellt ist. Im gezeigten Beispiel ist die poröse Scheibe 6 vor einem volumenhaltigen Zwischengefäß 7 angebracht, das auf der Gegenseite in ein Einweg-Niederdruckventil 4 mündet. Dem durch die poröse Scheibe 6 hindurchtretenden Heliumgas, insbesondere bei einer thermo-akustischen Schwingung, wird durch Gasreibung in den Kapillarkanälen der porösen Scheibe Bewegungsenergie entzogen. Das volumenhaltige Zwischengefäß 7 sorgt für ein freies Durchströmen des Gases durch die poröse Scheibe 6, indem es verhindert, daß auf der dem Einweg-Niederdruckventil 4 zugewandten Seite der Scheibe ein Gegendruck aufgebaut wird.

Die poröse Scheibe 6 kann entweder aus preisgünstigem Kunststoff oder aus Sintermaterial, insbesondere Sinterbronze bestehen und handelsüblichen Pneumatik-Schalldämpfern entnommen sein.

Um ein gleichmäßiges Verdampfen des Heliumgases zu erreichen und eine asymmetrische Energieabsorption in den einzelnen Abdampfleitungen 3 zu vermeiden, die zu unterschiedlichen Druck- und Temperaturverhältnissen in den Abdampfleitungen 3 und damit zu mechanischen Verspannungen mit schädlichen Rückwirkungen auf die Homogenität des Magnetfeldes führen würden, erweist es sich als günstig, die Energiedissipationsvorrichtungen symmetrisch und in gleicher Anzahl an allen Abdampfleitungen 3 vorzusehen.

Derselbe Effekt wird erreicht, wenn alle Abdampfleitungen 3 durch mindestens ein Verbindungsrohr 8 miteinander in Kontakt stehen. In diesem Fall kann, wie in Fig. 2 und Fig. 3a gezeigt, lediglich eine Vorrichtung zur Dissipation der Energie des bewegten Heliums, die an bzw. in dem Verbindungsrohr 8 vorgesehen ist, zu einer effektiven Schwingungsdämpfung ausreichen.

Bei Aufbau eines höheren Helium-Übderdruckes von mehr als den betriebsüblichen ca. 8mbar, wie es beispielsweise beim "Quenchen" und schlagartigen Erhitzen der supraleitenden Magnetspule 10 und damit des sie umgebenden flüssigen Heliums vorkommen kann, ist zur Vermeidung einer Explosion des Kryomagnetsystems üblicherweise ein Sicherheitsventil, meist in Form einer Berstscheibe 9, am Abdampfsystem vorgesehen. Bei Verwendung des in Fig. 2 gezeigten dünnwandigen Faltenbalgs 5, der keinem wesentlich größeren als dem betriebsüblichen Überdruck standhält und insbesondere bei einem durch ein Quenchen der supraleitenden Magnetspule 10 verursachten Druckstoß platzt, kann prinzipiell auch die Berstscheibe 9 eingespart werden.

## Patentansprüche

1. Kryomagnetsystem, insbesondere zur Anwendung bei Kernspinresonanz (NMR) - oder Ionen-Zyklotron-Resonanz (ICR)-Untersuchungen, mit einem verlustarmen Heliumkryostaten (1), der einen Heliumbehälter (2) und eine oder mehrere dünnwandige Leitungen für die Aufhängung des Heliumbehälters (2) und die Zufuhr bzw. Ableitung von Helium in den bzw. aus dem Heliumbehälter (2) umfaßt, wobei die Leitungen mit mindestens einem Einweg-Niederdruck-Ventil (4) gegen den Raum außerhalb des Heliumbehälters (2) abgeschlossen sind,
dadurch gekennzeichnet, daß
mindestens eine Abdampfleitung (3) eine Vorrichtung zur Dissipation der Energie bewegten Heliums aufweist, die aus einer von einer Abdampfleitung (3) abgezweigten Kammer besteht, deren wandmaterial eine hohe Dehnbarkeit und eine sehr geringe Federkonstante aufweist.

2. Kryomagnetsystem nach Anspruch 1, dadurch gekennzeichnet, daß die Kammer von einem dünnwandigen Faltenbalg (5) gebildet wird.

3. Kryomagnetsystem, insbesondere zur Anwendung bei Kernspinresonanz (NMR) - oder Ionen-Zyklotron-Resonanz (ICR)-Untersuchungen, mit einem verlustarmen Heliumkryostaten (1), der einen Heliumbehälter (2) und eine oder mehrere dünnwandige Leitungen für die Aufhängung des Heliumbehälters (2) und die Zufuhr bzw. Ableitung von Helium in den bzw. aus dem Heliumbehälter (2) umfaßt, wobei die Leitungen mit mindestens einem Einweg-Niederdruck-Ventil (4) gegen den Raum außerhalb des Heliumbehälters (2) abgeschlossen sind,
dadurch gekennzeichnet, daß
mindestens eine Abdampfleitung (3) eine Vorrichtung zur Dissipation der Energie bewegten Heliums aufweist, die aus einem in einer Abdampfleitung (3) vorgesehenen Strömungshindernis besteht.

4. Kryomagnetsystem nach Anspruch 3, dadurch gekennzeichnet, daß das Strömungshindernis von mindestens einer im Leitungsrohr der Abdampfleitung (3) angebrachten porösen Scheibe (6) gebildet wird.

5. Kryomagnetsystem nach Anspruch 4, dadurch gekennzeichnet, daß die poröse Scheibe (6) aus Kunststoff besteht.

6. Kryomagnetsystem nach Anspruch 4, dadurch gekennzeichnet, daß die poröse Scheibe (6) aus Sintermaterial, insbesondere Sinterbronze, besteht.

7. Kryomagnetsystem nach einem der Ansprüche 4 bis 6, dadurch gekennzeichnet, daß die poröse Scheibe (6) an einem dem Heliumbehälter (2) abgewandten Ende der Abdampfleitung (3) vor dem Einweg-Niederdruckventil (4) angeordnet ist.

8. Kryomagnetsystem nach Anspruch 7, dadurch gekennzeichnet, daß zwischen der porösen Scheibe (6) und dem Einweg-Niederdruckventil (4) ein Zwischengefäß (7) mit einem größeren Innendurchmesser als dem Leitungsinnendurchmesser vorgesehen ist.

9. Kryomagnetsystem nach einem der vorhergehenden Ansprüche, dadurch gekennzeichnet, daß Vorrichtungen zur Dissipation der Energie bewegten Heliums in symmetrischer Weise an allen Abdampfleitungen (3) vorgesehen sind.

10. Kryomagnetsystem nach einem der Ansprüche 1 bis 8, dadurch gekennzeichnet, daß alle Abdampfleitungen (3) durch mindestens ein Verbindungsrohr (8) miteinander in Kontakt stehen, und daß lediglich eine Vorrichtung zur Dissipation der Energie bewegten Heliums an bzw. in dem Verbindungsrohr (8) vorgesehen ist.

## Claims

1. Cryomagnet system, in particular for use with nuclear magnetic resonance (NMR) experiments or ion cyclotron resonance (ICR) experiments, with a low-loss helium cryostat (1) comprising a helium container (2) and one or a plurality of tubes with thin walls for the suspension of the helium container (2) and the feed or exit of helium into or out of the helium container (2), respectively, the tubes being sealed to the atmosphere outside the helium container (2) by at least one one-way low-pressure valve (4),
characterized in that
at least one exhaust pipeline (3) is provided with a device for dissipating the energy of moving helium, which device consists of a chamber which is deviated from an exhaust pipeline (3), the wall material of said chamber having high extensibility and a very low spring constant.

2. Cryomagnet system according to claim 1, characterized in that the chamber is formed by expansion bellows (5) with thin walls.

3. Cryomagnet system, in particular for use with nuclear magnetic resonance (NMR) experiments or ion cyclotron resonance (ICR) experiments, with a low-loss helium cryostat (1) comprising a helium container (2) and one or a plurality of tubes with thin walls for the suspension of the helium container (2) and the feed or exit of helium into or out of the helium container (2), respectively, the tubes being sealed to the atmosphere outside the helium container (2) by at least one one-way low-pressure valve (4),
characterized in that
at least one exhaust pipeline (3) comprises a device for dissipating the energy of moving helium which consists of a flow baffle provided in an exhaust pipeline (3).

4. Cryomagnet system according to claim 3, characterized in that the flow baffle is formed by at least one porous disc (6) provided in the conduit tube of the exhaust pipeline (3).

5. Cryomagnet system according to claim 4, characterized in that the porous disc (6) is made of synthetic material.

6. Cryomagnet system according to claim 4, characterized in that the porous disc (6) is made of sintered material, in particular sintered bronze.

7. Cryomagnet system according to any one of claims 4 to 6, characterized in that the porous disc (6) is arranged at one end of the exhaust pipeline (3) looking away from the helium container (2) before the one-way low-pressure valve (4).

8. Cryomagnet system according to claim 7, characterized in that an intermediate chamber (7) having a greater inner diameter than the inner diameter of the conduit tube is provided between the porous disc (6) and the one-way low-pressure valve (4).

9. Cryomagnet system according to any one of the preceding claims, characterized in that devices for dissipating the energy of moving helium are provided symmetrically at all exhaust pipelines (3).

10. Cryomagnet system according to any one of claims 1 to 8, characterized in that all exhaust pipelines (3) are in contact with one another by at least one connecting tube (8) and that only one device for dissipating the energy of moving helium is provided at or in the connecting tube (8), respectively.

## Revendications

1. Système cryomagnétique, en particulier en vue de l'application dans le cas de recherches de résonance nucléaire magnétique (RNM) ou de résonance cyclotron-ions (RCI), équipé d'un cryostat à hélium (1) à faibles pertes, qui comprend un réservoir d'hélium (2) et une ou plusieurs canalisations à paroi mince pour la suspension du réservoir d'hélium (2) et pour l'amenée ou l'évacuation d'hélium dans ou hors du réservoir d'hélium (2), les canalisations étant fermées vis-à-vis de l'espace extérieur au réservoir d'hélium (2) par au moins une soupape à basse pression à une voie (4),
caractérisé en ce qu'au moins une canalisation d'évaporation (3) comporte un dispositif en vue de la dissipation de l'énergie de l'hélium déplacé, qui se compose d'une chambre dérivée d'une canalisation d'évaporation (3), dont le matériau de paroi présente une extensibilité élevée et une très faible constante de ressort.

2. Système cryomagnétique selon la revendication 1, caractérisé en ce que la chambre est formée par un soufflet en accordéon à paroi mince (5).

3. Système cryomagnétique, en particulier en vue de l'application dans des recherches de résonance nucléaire magnétique (RNM) ou de résonance cyclotron-ions (RCI), équipé d'un cryostat à hélium (1) à faibles pertes, qui comprend un réservoir d'hélium (2) et une ou plusieurs canalisations à paroi mince pour la suspension du réservoir d'hélium (2) et pour l'amenée ou l'évacuation d'hélium dans ou hors du réservoir d'hélium (2), les canalisations étant fermées vis-à-vis de l'espace extérieur du réservoir d'hélium (2) par au moins une soupape à basse pression à une voie (4),
caractérisé en ce que
au moins une canalisation d'évaporation (3) comporte un dispositif en vue de la dissipation de l'énergie de l'hélium déplacé, qui se compose d'un obstacle à l'écoulement prévu dans une canalisation d'évaporation (3).

4. Système cryomagnétique selon la revendication 3, caractérisé en ce que l'obstacle à l'écoulement est constitué d'au moins un disque poreux (6) disposé dans le conduit de la canalisation d'évaporation (3).

5. Système cryomagnétique selon la revendication 4, caractérisé en ce que le disque poreux (6) est en matière plastique.

6. Système cryomagnétique selon la revendication 4, caractérisé en ce que le disque poreux (6) est en matériau fritté, en particulier en bronze fritté.

7. Système cryomagnétique selon l'une des revendications 4 à 6, caractérisé en ce que le disque poreux (6) est disposé à une extrémité de la canalisation d'évaporation (3) opposée au réservoir d'hélium (2) en amont de la soupape à basse pression à une voie (4).

8. Système cryomagnétique selon la revendication 7, caractérisé en ce qu'entre le disque poreux (6) et la soupape à basse pression à une voie (4) est prévu un réservoir intermédiaire (7) à diamètre intérieur supérieur au diamètre intérieur de la canalisation.

9. Système cryomagnétique selon l'une des revendications précédentes, caractérisé en ce que des dispositifs en vue de la dissipation de l'énergie de l'hélium déplacé sont prévus de manière symétrique sur toutes les canalisations d'évaporation (3).

10. Système cryomagnétique selon l'une des revendications 1 à 8, caractérisé en ce que toutes les canalisations d'évaporation (3) se trouvent en contact les unes des autres par au moins un tuyau de liaison (8), et en ce qu'uniquement un dispositif en vue de la dissipation de l'énergie de l'hélium déplacé est prévu sur ou dans le tuyau de liaison (8).
